# EUROPEAN PATENT APPLICATION

(11) **EP 4 780 151 A1**
(43) Date of publication of application: **22.07.2026**
(21) Application number: 25152144.9
(22) Date of filing: 16.01.2025
(51) Int. Cl.: H05K 7/20

(54) **ELECTRONIC CONTROL UNIT WITH A TEMPERING DEVICE AND TEMPERING DEVICE**

(71) Applicant: Connaught Electronics Ltd., County Galway H54 Y276 (IE)
(72) Inventor: KRISHNAMOORTHI, Preethkumar, 600130 Chennai (IN); RANA, Gyana-Ranjan, 600130 Chennai (IN); TROUT, Shane, Tuam, H54 Y276 (IE)
(74) Representative: Jauregui Urbahn, Kristian

(57) **Abstract**

The invention is directed at an electronic control unit (28) for a control device, wherein the electronic control unit (28) comprises a housing (30) with opposing housing walls, forming a housing interior, a circuit board (32) and at least one electronic component (34) arranged on the circuit board (32), wherein the circuit board (32) with the at least one electronic component (34) is arranged inside the housing interior, wherein the electronic control unit (28) comprises a tempering device with at least one vapor chamber (10) with a vapor chamber housing (12), which is in thermal contact with a heat dissipating surface of the at least one electronic component (34) and with at least one of the opposing housing walls, thus providing a thermal link therebetween.

## Description

The invention is directed at an electronic control unit (ECU) for a control device, preferably for an automotive control device. The ECU comprises a tempering device, which is designed to temper one or more of the electronic components of the ECU, which is arranged on a circuit board, preferably a printed circuit board (PCB), which is arranged inside a housing interior of a housing of the ECU. A further aspect of the invention is directed at a tempering device for such an ECU. A further aspect of the invention is directed at a motor vehicle comprising an electronic control unit with a tempering device.

With an increasing number of data processing steps in the context of the evolution of autonomous driving, the number and computing capacities of computing systems for vehicles increases, in particular electronic control units (ECU), domain control units (DCUs) or zone control units (ZPUs), for example for driver assistance systems or other semi-automatic or fully automatic driving functions. As a consequence, the thermal power dissipation (TDP - thermal dissipation of power) of the different electronic components of such computing systems is increasing as well. Whereas initially, the TDP was in the order of about two to ten Watts, the TDP of electronic components in modern ECUs may reach 30 Watts or more. Thermal power dissipation of this order cannot be efficiently cooled by using passive cooling methods like air cooling anymore.

One solution of cooling such high-tempered electronic components may consist of the use of liquid cooling systems, which is not practicable in the automotive context due to the risk of liquid-induced short circuits in the computing systems, for example in the ECUs. Apart from this, often the limited assembly space within automotive control devices does not allow the use of liquid cooling systems in the vehicle computing systems.

WO 2024 034 632 A1 discloses the use of a vapor chamber as a tempering or cooling device. The working principle of a vapor chamber is based on a repeated phase change of a working fluid, for example ionized water, inside the chamber. More specifically, the working fluid in the vapor chamber receives heat from the device that is to be cooled at an evaporation section close to the device. Inside the chamber, the working fluid evaporates into working steam or vapor. The working vapor is diffused in a direction away from the evaporation section within a vapor flow path section formed within the vapor chamber. At a condensation section, the diffused working vapor is cooled and condensed to become working fluid again, thereby giving off heat. A liquid flow path section serving as a capillary structure is provided within the vapor chamber. The working fluid flows through the liquid flow path section and is transported back towards the evaporation section. There, it may receive heat again and evaporate. In this way, the working fluid circulates within the vapor chamber while repeating phase changes, that is, evaporation and condensation, thereby diffusing and releasing heat from the device to be cooled.

Also, US 2021/0247822 A1 discloses a cooling system for an electronic device with such a vapor chamber.

The known solutions are not suitable for the use in an automotive control unit as they are not compatible with the limited assembly space within a typical automotive control unit environment. Therefore, there still exists a need for providing a way of efficiently tempering an automotive computing system, especially in the high thermal power dissipation range of 30 Watts or more.

It is an object of the invention to provide a way of efficiently tempering an automotive control unit, especially in the high thermal power dissipation range of 30 Watts or more.

This object is solved by the subject-matter of the independent claims. Advantageous embodiments of the invention are described by the dependent claims, the following description and the figures.

The invention is directed at control unit, in particular an electronic control unit, for a control device, preferably for an automotive control device (short: automotive ECU). Such a control device can for example be a motor control device of a motor vehicle. The electronic control unit according to the invention comprises a housing with opposing housing walls, forming a housing interior. Here and in the following, the housing of the control unit is often referred to as "ECU housing". It is understood, that the housing can also be a housing of a domain control unit (DCU housing) and/or a housing of a zone control unit (ZPU housing).

The control unit according to the invention further comprises a circuit board, preferably a printed circuit board, and at least one electronic component arranged on the circuit board. The printed circuit board is used in particular for mechanical fastening and electrical connection of the electronic component.

In particular, the printed circuit board can carry the at least one electronic component, preferably several electronic components, which can generate waste heat during operation, which is to be dissipated by the tempering device.

The electronic component can for example be a processor, preferably a microprocessor, or any other data processing device with high thermal power dissipation, for example with a thermal power dissipation of 30 Watts or more.

In the control unit according to the invention, the circuit board with the at least one electronic component is arranged inside the housing interior. In other words, the circuit board with the at least one electronic component arranged on it is shielded by the housing material from any influences from the outside of the housing. The housing may for example be made of or comprise copper, aluminum or a copper-aluminum alloy.

According to the invention, the electronic control unit comprises a tempering device with at least one vapor chamber with a vapor chamber housing, which is in thermal contact with a heat dissipating surface of the at least one electronic component and with at least one of the opposing housing walls, thus providing a thermal link therebetween. In other words, the housing of the vapor chamber, which may also be made of or comprise copper, aluminum or a copper-aluminum alloy, is in thermal contact with the heat dissipating surface on one hand and with at least one of the housing walls of the ECU housing on the other hand. To achieve the thermal link between the heat dissipating surface of the electronic component and the housing wall, the housing of the vapor chamber may be in direct contact with either one of them or with both. In other words, the vapor chamber housing may be arranged between the heat dissipating surface of the electronic component and a surface of the housing wall. Therein, a contacting surface of the vapor chamber housing with the heat dissipating surface of the electronic component may be smaller, equal to or larger than the same. To enhance the transfer of thermal energy from the electronic component to the vapor chamber, a thermal interface material (TIM) may be arranged between the heat dissipating surface of the electronic component and the housing of the vapor chamber. Alternatively or additionally, such a TIM may be arranged between the vapor chamber housing and the housing wall of the ECU housing.

The invention is advantageous in that it allows a compact construction of a control unit, in particular of a vehicle ECU, with efficient cooling of its electronic components. Thus, also a limited assembly space may efficiently be used. The compact construction is possible due to the thermal contact between the vapor chamber and the housing of the control unit. No additional heat transfer elements, such as heat pipes or the like, are needed for efficient tempering of the electronic component.

Various embodiments of the invention provide additional advantages.

According to an embodiment, the vapor chamber housing is at least partially or fully integrated into a recess or grove inside a surface of the at least one of the housing walls of the housing of the electronic control unit. In other words, the vapor chamber housing may be inserted in said recess or grove inside the surface of the housing wall. Preferably, the recess or grove may be adapted to the outer dimensions of the vapor chamber housing such that the vapor chamber housing and the surface of the housing wall of the ECU housing, which comprises the recess, abut one another seamlessly. Irregularities of the abutting surfaces may be equaled out by using a thermal interface material between the abutting surfaces, for example a thermally conductive paste. Like this, the limited assembly space within the automotive ECU is even more efficiently used, while reliable cooling of the at least one electronic component of the ECU is provided.

According to a further embodiment, the surface with the recess faces the housing interior of the housing of the electronic control unit. In other words, the housing of the vapor chamber is arranged inside the housing interior of the ECU housing. Like this, the vapor chamber is shielded by the ECU housing from influences from outside the ECU. In this shielded environment, the thickness of the walls of the vapor chamber housing can be reduced to about one to three millimeters. In other words, the vapor chamber as a whole does not need to be very robust and therefore can be very thin, for example on the order of a few millimeters to approximately one centimeter. Like this, additional assembly space may be reduced compared to the known ECU designs, while reliable cooling is provided.

As an alternative, the surface with the recess faces the housing exterior of the housing of the electronic control unit. In other words, the vapor chamber housing may be fitted into the recess from the outside of the ECU, preferably such that the vapor chamber housing and the surface of the housing wall of the ECU housing, which comprises the recess, abut one another seamlessly. Like this, the ECU may be complemented with the tempering device, comprising the vapor chamber, in a retrofit measure.

According to a further embodiment, the vapor chamber housing at least partially forms part of at least one of the housing walls of the housing of the electronic control unit. In other words, the vapor chamber housing may be formed of or comprise the same material as the ECU housing wall of which it forms part. The outer dimensions of the vapor chamber housing may correspond to geometric properties of the ECU housing wall of which it forms part. For example, the vapor chamber housing may be essentially equal in thickness compared to the ECU housing wall. For example, the functional elements of the vapor chamber, especially the evaporation section, the condensation section and the liquid flow path, may be arranged inside a void, which may be formed inside the ECU housing wall. In other words, the functional components of the vapor chamber may be formed integrally with the ECU housing wall. Like this, the existing assembly space for the ECU may be used even more efficiently, while reliable cooling of the electronic components of the ECU is provided.

In a further embodiment, the vapor chamber housing at least partially provides at least one of the opposing housing walls of the housing of the electronic control unit. In other words, according to this embodiment, the vapor chamber may replace one of the opposing walls of the ECU housing, for example a lid of the ECU housing. In an extreme implementation, all of the walls of the ECU housing may be formed by vapor chamber housings of the described type. The housing wall thicknesses of the walls of the vapor chamber housing would have to be increased compared with other embodiments, in order to provide the necessary robustness. Nevertheless, such an arrangement may further enhance the abovementioned advantages due to the two-in-one functionality of the vapor chamber housings.

According to a further embodiment, the electronic control unit comprises an outwardly directed heat dissipating structure, which is arranged on an outside surface of at least one of the housing walls of the housing of the electronic control unit, wherein the outside surface faces away from the housing interior of the housing of the electronic control unit. The heat dissipating structure is designed to enlarge the outside surface of the at least one of the housing walls of the ECU housing in order to further increase the cooling effect. As described, by means of the vapor chamber, thermal power or heat is dissipated from the electronic component of the ECU to at least one of the housing walls of the ECU housing. The outwardly directed heat dissipating structure on the outside surface of this housing wall provides increased heat dissipation towards the outside of the ECU housing. The heat dissipating structure may have any geometric shape, for example ribs or fins or the like. The structure may be made from or comprise the same material as the housing wall of the ECU housing from which it may protrude. The structure may be formed integrally with the housing wall of the ECU housing. As an alternative, the structure may be welded or glued or screwed onto the housing wall of the ECU housing as a retrofit measure.

As described, the outwardly directed heat dissipating structure may comprise heat dissipating fins, which protrude from the outside surface of the at least one of the housing walls of the housing of the electronic control unit. Preferably, the heat dissipating structure, for example the fins, at least partially forms part of the at least one wall of the housing of the electronic control unit.

Preferably, the heat dissipating structure comprises a base plate, which at least partially forms part of the at least one wall of the housing of the electronic control unit, wherein the fins protrude from the base plate. The base plate may for example replace one of the housing walls of the ECU housing. The base plate may also form an outer wall of the vapor chamber housing, which may replace one of the walls of the ECU housing. In other words, the fins may protrude directly from the outer wall of the vapor chamber housing.

According to a further development, the heat dissipating structure, preferably the base plate, is at least partially integrated into a recess or grove inside the outside surface of the at least one of the housing walls of the housing of the electronic control unit. Preferably, the heat dissipating structure, preferably at least the base plate, is made from the same material as the at least one housing wall of the housing of the electronic control unit.

As described, the fins of the heat dissipating structure may protrude from the base plate, which may be inserted into the recess. As an alternative, the base plate may be integrated into the housing wall of the ECU housing, such that it provides the housing wall at least partially. In other words, the housing wall may at least partially be replaced by the base plate of the heat dissipating structure.

As described, according to an embodiment, the vapor chamber housing may at least partially replace one of the housing walls of the ECU housing. In the context of this embodiment, an outwardly oriented surface of the vapor chamber housing may be used as the base plate of the heat dissipating structure. In other words, the heat dissipating structure, for example the fins, may protrude from the outwardly oriented surface of the vapor chamber housing. The fins may be integrally formed with the outwardly oriented surface of the vapor chamber housing. In other words, the vapor chamber housing and the fins may be formed as one part. As an alternative, the fins may be welded or glued or screwed or stamped onto the vapor chamber housing. Like this, one housing wall of the ECU housing can be replaced with the vapor chamber housing with the attached or integrated fins. Like this, the number of components that are used to build the electronic control unit housing can be reduced.

As described, thermal interface material (TIM) may be used to enhance the heat transfer capacity and/or to equal out irregularities between the vapor chamber and other components, for example the electronic component that needs to be cooled. According to one embodiment, a sheet of thermal interface material is arranged on at least one surface of the vapor chamber housing to provide these additional effects.

According to a further embodiment, the electronic control unit further comprises a heat spreading device, preferably comprising a fan, which is arranged outside the housing of the electronic control unit and which is designed to further spread heat dissipated from the electronic component to the housing of the electronic control unit via the vapor chamber. In other words, the heat spreading device is designed to cool the ECU housing from the outside, for example by using a fan, which is directed to the fins of the heat dissipating structure. In other words, the fan can be designed to direct a tempered air volume flow towards the outwardly directed heat dissipating structure.

The control unit according to the invention preferably is an automotive electronic control unit (ECU), which can be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the control unit according to the invention is integrated into an electronic assembly, which can be a main controller of the motor vehicle. Alternatively, the electronic assembly may be a zonal controller of the motor vehicle. Accordingly, the tempering device according to the invention can be provided for tempering or cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the tempering device.

A further aspect of the invention is directed at a tempering device for an electronic control unit, comprising at least one vapor chamber and preferably also a heat spreading device.

A further aspect of the invention relates to a motor vehicle with at least one electronic control unit according to the invention.

Further embodiments of the tempering device and/or the motor vehicle according to the invention follow directly from the various embodiments of the electronic control unit according to the invention and vice versa. In particular, individual features and corresponding explanations as well as advantages relating to the various implementations of the electronic control unit according to the invention can be transferred analogously to implementations of the tempering device and/or the motor vehicle according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

In the figures:
- Fig. 1: shows a schematic drawing of a vapor chamber for illustrating its working principle;
- Fig. 2: shows a schematic exploded view of an electronic control unit with a tempering device according to an embodiment of the invention; and
- Figs. 3 to 7: show schematic drawings of a respective electronic control unit with a tempering device according to various embodiments of the invention.

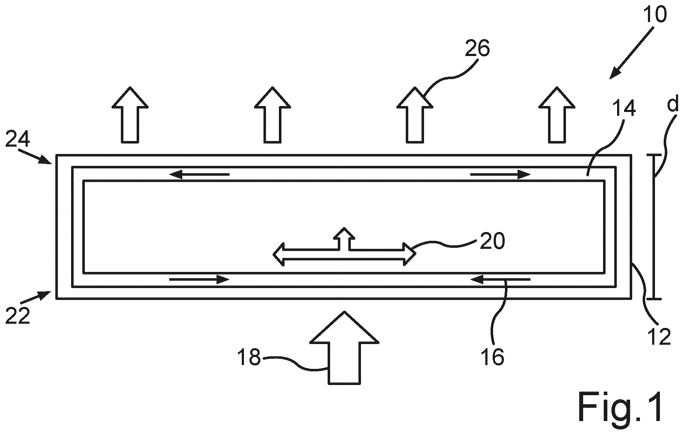

Fig. 1 shows a schematic drawing of a vapor chamber 10. The vapor chamber 10 comprises a housing 12, herein referred to as vapor chamber housing 12. Inside the vapor chamber housing 12, there is a liquid flow path 14, which may comprise a sponge-like material, comprising connected pore space to absorb the vapor chamber's working fluid, represented by arrows 16.

According to the general working principle of the vapor chamber 10, the working fluid 16, for example ionized water, evaporates due to heat 18 being transferred to the vapor chamber 10 from the outside of the vapor chamber 10, for example through conductive and/or convective heat flow from a component adjacent to the vapor chamber 10, having a higher temperature or thermal power dissipation than the vapor chamber 10 itself. During the evaporation process, the liquid working fluid 16 turns into working steam or vapor 20. According to its reduced density compared to the liquid state, the vapor 20 diffuses from an evaporation section 22 towards a condensation section 24, where it is cooled down and condensates to the liquid state. During condensation, condensation heat is released and dissipated to the outside (arrows 26). The condensed working fluid 16 flows along the liquid flow path 14 back towards the evaporation section 22, where the phase transition is repeated.

The material of the vapor chamber housing 12 may be or comprise a metal, for example copper and/or aluminum and/or an allow thereof. The vapor chamber housing 12 may have a total thickness d of about three to five millimeters.

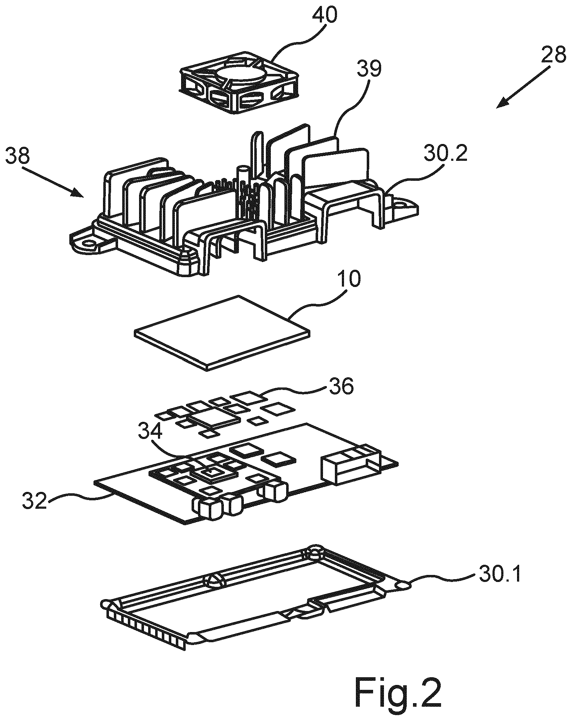

Fig. 2 shows a schematic exploded view of an electronic control unit 28, comprising a housing 30, which in the present example consists of a lower part 30.1 and an upper part 30.2. Between the lower and the upper part 30.1, 30.2 of the ECU housing 30, a circuit board 32 with several electronic components 34 mounted thereon is arranged. The electronic components 34 may be soldered onto the circuit board 32. On top of one or more or all of the electronic components 34, there may be arranged a thin sheet of thermal interface material 36. The thermal interface material 36 may be present as a thermally conductive paste or as a thermally conductive pad, which may have a geometry, which corresponds to the shape of a respective electronic component 34. For the ease of appliance, the thermal interface material 36 may also just be applied as a coating covering all of the electronic components 34. On top of the thermal interface material 36, there may be a vapor chamber 10 with a vapor chamber housing 12 as described in the context of Fig. 1. In other words, in the shown arrangement, the vapor chamber 10 is arranged between the electronic components 34 and the upper part 30.2 of the ECU housing 30, thus being in thermal contact with a heat dissipating surface of one or more or all of the electronic components 34 on one hand and with the upper part 30.2 of the ECU housing 30 on the other hand. In this position, heat can be transferred efficiently by the vapor chamber 10 from the electronic components 34 to the upper housing part 30.2. The thermal interface material 36 may facilitate the heat transfer.

In the shown arrangement, the upper part 30.2 of the ECU housing 30 comprises a heat dissipating structure 38, for example comprising several fins 39, which protrude from the outside surface of the upper housing part 30.2. In other words, the fins 39 enlarge the outside surface area of the upper housing part 30.2, thereby increasing heat dissipation from the outside surface of the upper housing part 30.2 towards an area outside the ECU 28. In the shown example of Fig. 2, the fins 39 and the upper housing part 30.2 are formed as one piece from the same material, for example during a casting process.

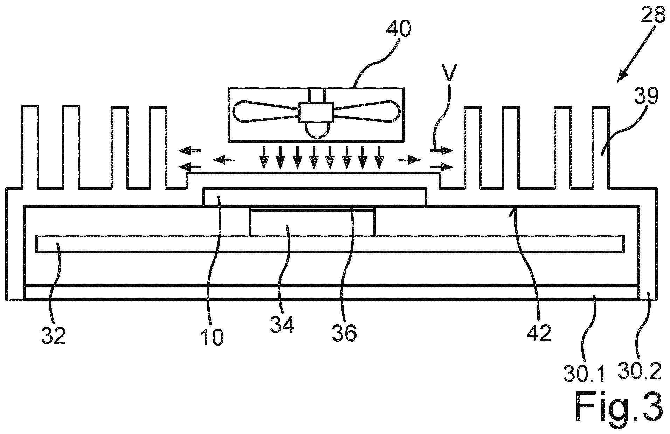

In the example of Fig. 2, there is a further heat spreading device 40, for example in the form of a fan 40, arranged on the outside surface of the upper part 30.2 of the ECU housing 30. The fan 40 may be arranged such that it directs a tempered air volume flow v (see Fig. 3) towards the fins 39 for cooling the fins 39 and for enhancing heat transfer from the upper housing part 30.2 towards the area outside the ECU 28.

Fig. 3 shows, with reference to the components shown and described with regard to Figs. 1 and 2, a further schematic drawing of an electronic control unit 28. Here, the upper housing part 30.2 comprises a recess inside a surface 42, which faces the interior of the ECU housing 30. Inside the recess, the vapor chamber 10 with its vapor chamber housing 12 is arranged. The geometry of the vapor chamber housing 12 corresponds to the shape of the recess and vice versa, such that the vapor chamber housing 12 and the surface 42 abut seamlessly against each other.

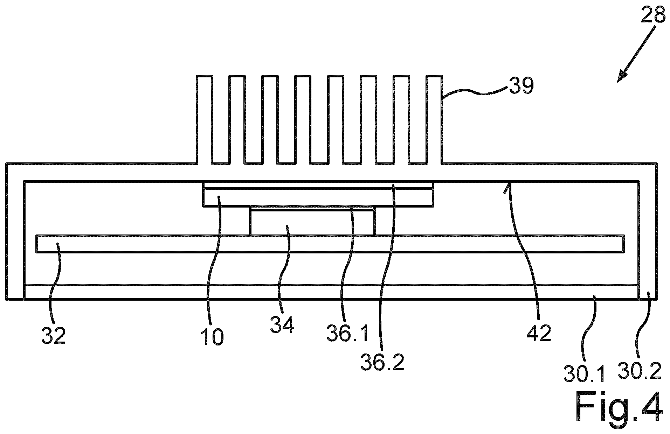

Fig. 4 shows, also with reference to the above-described components, a further schematic drawing of an electronic control unit 28, wherein in this example, the upper housing part 30.2 and the fins 39 are also formed as one piece, preferably from the same material and in the same production step. Between the vapor chamber housing 12 and the surface 42 of the upper housing part 30.2, there is a second sheet of thermal interface material 36.2. In other words, in the shown example, the vapor chamber 10 is sandwiched between two sheets of thermal interface material 36.1 and 36.2, thus further enhancing heat transfer from the electronic component 34 to the upper housing part 30.2.

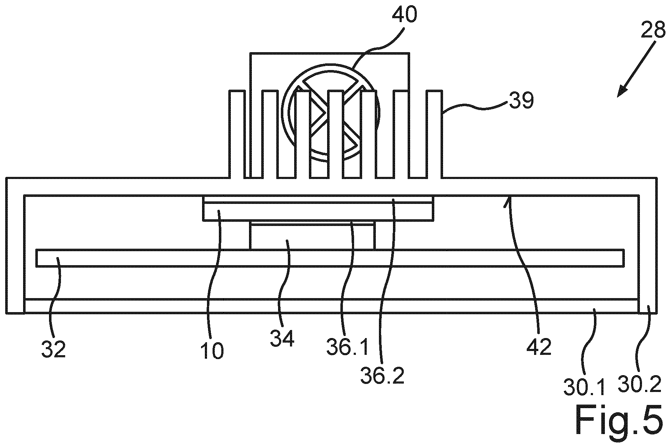

Fig. 5 shows the same example as Fig. 4, the only difference being the fan 40, which is vertically mounted with respect to the fins 39, thus blowing the heat from in between the fins 39 towards the area outside of the ECU 28.

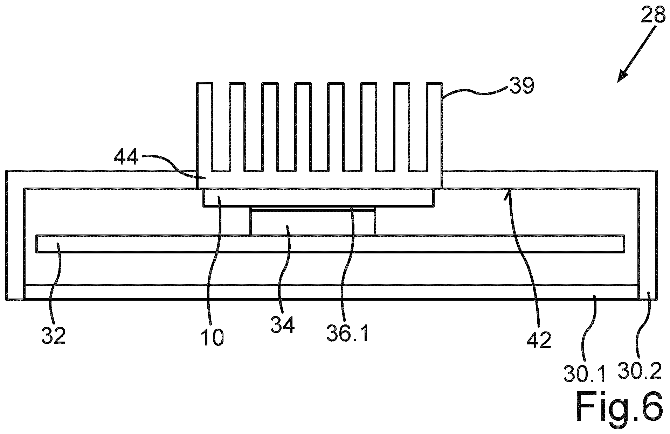

Fig. 6 shows a further example of an ECU 28, again with reference to what has already been described above. Here, the heat dissipating structure 38 at least partially forms part of the upper housing part 30.2. In other words, there is a gap within one of the walls of the upper housing part 30.2, inside which a base plate 44 of the dissipating structure 38 is arranged. The fins 39 and the base plate 44 may be formed as one piece. The fins 39 may protrude from the base plate 44 essentially vertically. The heat dissipating structure 38 as a whole, that is the base plate 44 and the fins 39, may be formed of or comprise the same material as the upper housing part 30.2, for example a metal, preferably copper and/or aluminum or an alloy thereof.

In a further example (not shown), the base plate 44 of Fig. 6 may form a wall of the vapor chamber housing 12. In other words, the heat dissipating structure 38 and the vapor chamber housing 12 may be formed as one piece. For example, a stack of stamped fins 39 can be soldered directly onto a surface of the vapor chamber housing 12, which in this case acts as base plate 44.

In still a further example, the vapor chamber housing 12 may be combined with the ECU housing 30 as a single part or as one piece to make the arrangement thermally even more efficient. Also in this example, the fins 39 can be soldered directly onto the surface of the vapor chamber housing 12.

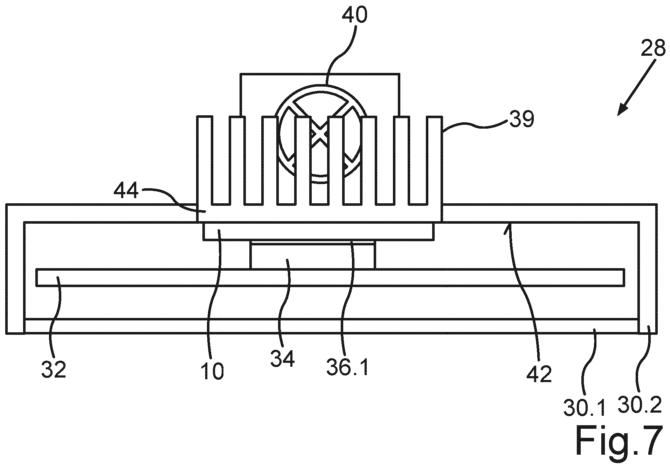

Fig. 7 shows the arrangement of Fig. 6 with a fan 40 being arranged essentially vertically with respect to the fins 39.

In all of the shown examples, the dimension and type of the vapor chamber 10 may vary with the thermal power dissipation of the electronic components 34 and with available assembly space. The examples show a flexible yet efficient way of heat transfer for tempering an ECU using a vapor chamber cooling system.

## Claims

1. Electronic control unit (28) for a control device, wherein the electronic control unit (28) comprises
- a housing (30) with opposing housing walls, forming a housing interior,
- a circuit board (32) and
- at least one electronic component (34) arranged on the circuit board (32),
wherein the circuit board (32) with the at least one electronic component (34) is arranged inside the housing interior,
wherein the electronic control unit (28) comprises a tempering device with at least one vapor chamber (10) with a vapor chamber housing (12), which is in thermal contact with a heat dissipating surface of the at least one electronic component (34) and with at least one of the opposing housing walls, thus providing a thermal link therebetween.

2. Electronic control unit (28) according to claim 1, wherein the vapor chamber housing (12) is at least partially or fully integrated into a recess inside a surface (42) of the at least one of the housing walls of the housing (30) of the electronic control unit (28).

3. Electronic control unit (28) according to claim 2, wherein the surface (42) faces the housing interior or an area outside of the housing (30) of the electronic control unit (28).

4. Electronic control unit (28) according to any of the preceding claims, wherein the vapor chamber housing (12) at least partially forms part of at least one of the housing walls of the housing (30) of the electronic control unit (28).

5. Electronic control unit (28) according to any of the preceding claims, wherein the vapor chamber housing (12) at least partially provides at least one of the opposing housing walls of the housing (30) of the electronic control unit (28).

6. Electronic control unit (28) according to any of the preceding claims, comprising an outwardly directed heat dissipating structure (38), which is arranged on an outside surface of at least one of the housing walls of the housing (30) of the electronic control unit (28), wherein the outside surface faces away from the housing interior of the housing (30) of the electronic control unit (28).

7. Electronic control unit (28) according to claim 6, wherein the outwardly directed heat dissipating structure (38) comprises heat dissipating fins (39), which protrude from the outside surface of the at least one of the housing walls of the housing (30) of the electronic control unit (28).

8. Electronic control unit (28) according to any of claims 6 or 7, wherein the heat dissipating structure (38) comprises a base plate (44), which at least partially forms part of the at least one wall of the housing (30) of the electronic control unit (28), wherein the fins (39) protrude from the base plate (44).

9. Electronic control unit (28) according to any of claims 6 to 8, wherein the heat dissipating structure (38) is at least partially integrated into a recess inside the outside surface of the at least one of the housing walls of the housing (30) of the electronic control unit (28).

10. Electronic control unit (28) according to any of claims 6 to 9, wherein the heat dissipating structure (38) is made from the same material as the at least one housing wall of the housing (30) of the electronic control unit (28).

11. Electronic control unit (28) according to any of the preceding claims, wherein a sheet of thermal interface material (36) is arranged on at least one surface of the vapor chamber housing (12).

12. Electronic control unit (28) according to any of the preceding claims, comprising a heat spreading device (40), which is arranged outside the housing (30) of the electronic control unit (28) and which is designed to further spread heat dissipated from the electronic component (34) to the housing (30) of the electronic control unit (28).

13. Electronic control unit (28) according to claim 12, wherein the heat spreading device (40) comprises a fan.

14. Electronic control unit (28) according to claim 13, wherein the fan is designed to direct a tempered air volume flow (v) towards the outwardly directed heat dissipating structure (38).

15. Tempering device for an electronic control unit (28) according to any of the preceding claims, comprising at least one vapor chamber (10) and preferably a heat spreading device (40).
